Europäisches Patentamt

European Patent Office

Office européen des brevets

(19)

(11) Numéro de publication : **0 055 949**
**B1**

(12) **FASCICULE DE BREVET EUROPÉEN**

(45) Date de publication du fascicule du brevet :
09.10.85

(51) Int. Cl.⁴ : **G 03 B 41/00, H 01 L 21/68**

(21) Numéro de dépôt : **81401868.5**

(22) Date de dépôt : **25.11.81**

(54) **Dispositif de positionnement automatique d'une pièce, telle qu'un support de composants électroniques, sur une table de travail.**

(30) Priorité : 24.12.80 FR 8027417

(43) Date de publication de la demande :
14.07.82 Bulletin 82/28

(45) Mention de la délivrance du brevet :
09.10.85 Bulletin 85/41

(84) Etats contractants désignés :
CH DE FR GB IT LI NL SE

(56) Documents cités :
TECHNICAL DIGEST WESTERN ELECTRIC, no. 31, juillet 1973 NEW YORK (US) J.F. POKORNY et al. "Substrate position indicator" pages 45 et 46
TECHNICAL DIGEST WESTERN ELECTRIC, no. 51, juillet 1978 NEW YORK (US) R. CHMIELEWSKI "Aligning fixture for supporting a substrate and a mask", pages 9 et 10
IBM TECHNICAL DISCLOSURE BULLETIN, volume 20, no. 1, juin 1977 NEW YORK (US) M.J. FEUER "Fixture for precisely holding substrates", pages 161 et 162
IBM TECHNICAL DISCLOSURE BULLETIN, volume 22, no. 1, juin 1979 NEW YORK (US) H.E. HANSEN et al. "Convertible wafer size gripper assembly" pages 120 et 121

(73) Titulaire : **CII HONEYWELL BULL**
**94 Avenue Gambetta**
**F-75990 Paris Cedex 20 (FR)**

(72) Inventeur : **Colineau, Robert Constant**
**94 Avenue Gambetta**
**F-75020 Paris (FR)**

(74) Mandataire : **Denis, Hervé et al**
**CII-HONEYWELL BULL 94, avenue Gambetta**
**F-75960 Paris Cedex 20 (FR)**

## Description

L'invention concerne généralement un dispositif de positionnement automatique d'une pièce,
telle qu'un support de composants électroniques,
sur une table de travail où ce support doit
occuper avec précision une position déterminée
par rapport à un système de référence porté par la
table, et elle s'applique notamment dans une
machine de sérigraphie pour le positionnement
automatique d'un support sur la table de travail
de cette machine pour la fabrication de circuits
de connexions à couches épaisses multiples
déposées sur le support avant de monter les
composants électroniques reliés électriquement
entre eux par ces circuits de connexions.

De façon générale, les produits industriels dans
de nombreuses applications nécessitent des
outils très précis et des procédés d'assemblage
ou de montage tolérant un minimum de jeu entre
les pièces constituant ces produits. Dans tous les
cas, la précision de l'usinage ou du montage est
également conditionnée par la précision du positionnement de ces pièces les unes par rapport
aux autres, et plus généralement de la position de
ces pièces vis-à-vis d'une table de travail utilisée
au cours de l'usinage ou au cours du montage.

Dans l'industrie électronique notamment et
dans le but de réaliser des circuits encore plus
performants et de les rassembler dans un volume
toujours plus réduit, les constructeurs ont été
conduits à utiliser des microplaquettes de circuits
intégrés, désignées communément sous le nom
de « puces » (« chips » en anglais), et à les monter sur des supports dont les conducteurs sont
répartis en plusieurs plans séparés les uns des
autres par des couches isolantes, sauf en certains
points déterminés où des colonnes conductrices
assurent des liaisons électriques entre des
conducteurs situés dans des plans différents.

La fabrication de ces supports est généralement réalisée à l'aide d'une machine de sérigraphie qui permet de déposer sur une plaque
électriquement isolante, par exemple en alumine,
une série de couches alternativement conductrices et isolantes, chaque couche étant obtenue
par application, au travers d'un écran dont le
motif transparent correspond à celui de la couche
à réaliser, d'une matière pâteuse qui est soit
conductrice, soit isolante.

Afin de pouvoir réaliser des connexions électriques entre des conducteurs situés dans des plans
différents, il est indispensable que, non seulement les écrans qui sont montés successivement
dans la machine de sérigraphie pour déposer ces
couches soient positionnés avec une très grande
précision les uns par rapport aux autres, mais
également que le support qui est mis à chaque
fois en place dans la machine de sérigraphie pour
recevoir une couche soit également parfaitement
positionné par rapport à l'écran.

Dans l'article de Pokorny et al. dans la revue
« Technical Digest » de Western Electric, n° 31,
juillet 1973, il est notamment décrit des moyens pour positionner un support sur une table de
travail dans le quadrant d'un système de référence défini par trois points constitués par trois
butées. Ce système de référence cartésien a un
premier axe défini par deux butées alors que le
second axe perpendiculaire au premier axe passe
par la troisième butée, ce second axe coupant le
premier axe en dehors de la portion d'axe
comprise entre les deux butées définissant le
premier axe.

Pour positionner le support par rapport à ce
système de référence, c'est-à-dire appliquer deux
côtés latéraux adjacents du support contre ces
trois butées (deux butées pour un côté et la
troisième butée pour l'autre côté latéral), il est
prévu deux bras presseurs rétractables dans un
plan parallèle à la table de travail pour la mise en
place du support sur cette table dans ledit quadrant et venant respectivement s'appuyer sur les
deux autres côtés du support. Autrement dit, le
support est positionné sur la table contre les trois
butées du système de référence, puis par l'intermédiaire d'un système manuel de commande, les
deux bras presseurs se déplacent pour maintenir
le substrat en contact avec les trois butées du
système de référence.

Dans le but d'automatiser la mise en place d'un
tel support et plus généralement d'une pièce telle
que ce support sur une table de travail, l'invention
prévoit un dispositif de positionnement automatique susceptible de contribuer à l'automatisation
de la fabrication et/ou du montage des pièces
constitutives d'un produit industriel.

A cet effet, l'invention propose un dispositif de
positionnement automatique d'une pièce rectangulaire, telle qu'un support de composants électroniques, sur une table de travail comprenant
trois butées fixes définissant le quadrant d'un
système de référence et recevant deux côtés
adjacents du support, et deux bras presseurs
rétractables dans un plan sensiblement parallèle
à la table de travail pour la mise en place du
support sur la table dans le quadrant et venant
respectivement s'appuyer sur les deux autres
côtés du support, caractérisé en ce que les deux
bras presseurs sont respectivement solidaires,
par une de leurs extrémités, de deux axes verticaux entraînés en rotation en sens inverse l'un de
l'autre par un organe moteur unique pour amener
d'abord l'un puis l'autre desdits deux côtés adjacents contre leurs butées respectives.

Selon un avantage important du dispositif
conforme à l'invention, le support est positionné
automatiquement par rapport aux trois butées du
système de référence, ce positionnement s'effectuant en deux temps : dans un premier temps par
rapport aux deux butées définissant un premier
axe du système de référence, et dans un
deuxième temps par rapport à la troisième butée
définissant le second axe de ce système de
référence. Dans l'article précité, on se contente
uniquement de dire que le positionnement effectué manuellement est maintenu par l'intermédiaire de deux bras presseurs.

Selon une autre caractéristique du dispositif conforme à l'invention, cet organe moteur unique est constitué par un vérin dont le corps et la tige de piston sont montés flottants, avec le corps de vérin solidaire d'une première crémaillère mobile qui engrène un premier pignon fixe solidaire en rotation de l'axe d'entraînement de l'un des bras de positionnement, et avec la tige de piston solidaire, d'une seconde crémaillère mobile, parallèle à la première crémaillère, et qui engrène un deuxième pignon fixe solidaire en rotation de l'axe d'entraînement de l'autre bras de positionnement.

Avec un tel organe moteur, lorsque le vérin est sous pression, le corps du vérin et la tige du vérin se déplacent dans deux directions opposées, les deux crémaillères entraînant dans deux sens de rotation différents les deux pignons solidaires des deux bras de positionnement, entraînant ainsi le pivotement de ces deux bras dans deux directions opposées les amenant respectivement en contact avec les deux côtés latéraux adjacents du support qui ne sont pas destinés à venir en contact avec les butées du système de référence.

Pour pouvoir respecter le positionnement en deux temps du support par rapport au système de référence, il faut que le bras affecté au positionnement du support contre les deux premières butées du système de référence agisse avant le bras affecté au positionnement du support contre la troisième butée du système de référence.

Aussi, selon une autre caractéristique du dispositif conforme à l'invention, le déplacement de la crémaillère qui entraîne le pivotement du bras de positionnement associé à la troisième butée du système de référence est freiné, par une lame frein par exemple, pour favoriser le déplacement de l'autre crémaillère, cette lame frein entraînant donc un retard du pivotement du bras assurant le positionnement du support contre la troisième butée du système de référence.

L'avantage important d'un tel dispositif de commande est qu'il est unique, ce qui simplifie d'autant la structure du dispositif de positionnement conforme à l'invention, tout en assurant un positionnement précis du support.

D'autres avantages, caractéristiques et détails ressortiront de la description explicative qui va suivre, faite en référence aux dessins annexés dans lesquels :

la figure 1 est une vue de dessus du dispositif de positionnement conforme à l'invention monté sur une table de travail comprenant une platine sur laquelle est montée une plaque portant le système de référence,

la figure 2 est une vue suivant la flèche (II) de la figure 1 et limitée uniquement à la platine de la table de travail,

la figure 3 est une vue suivant la flèche (III) de la figure 1 et limitée à la platine de la table de travail,

la figure 4 est une vue en perspective schématique pour illustrer le principe de fonctionnement du dispositif de positionnement conforme à l'invention,

la figure 5 est une vue en coupe agrandie suivant la ligne (V-V) de la figure 1, et

la figure 6 est une vue en coupe suivant la ligne (VI-VI) de la figure 1, limitée à la plaque de la table de travail comprenant le système de référence.

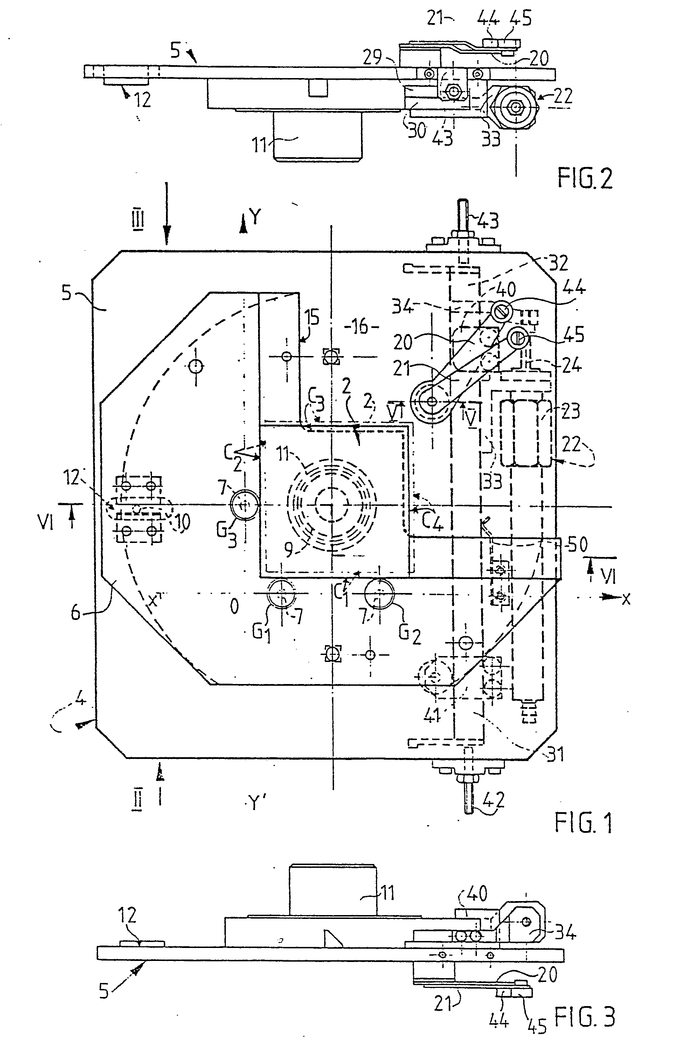

En se référant aux figures 1 à 3 le dispositif de positionnement (1) conforme à l'invention représenté à titre d'exemple sert à positionner une pièce (2) telle qu'un support de composants électroniques, par rapport à un système de référence (3) d'une table de travail (4).

La table de travail (4) se compose de deux parties à savoir une platine (5) qui supporte le dispositif de positionnement (1), et une plaque (6) qui supporte le système de référence (3), plaque rapportée sur la platine (5).

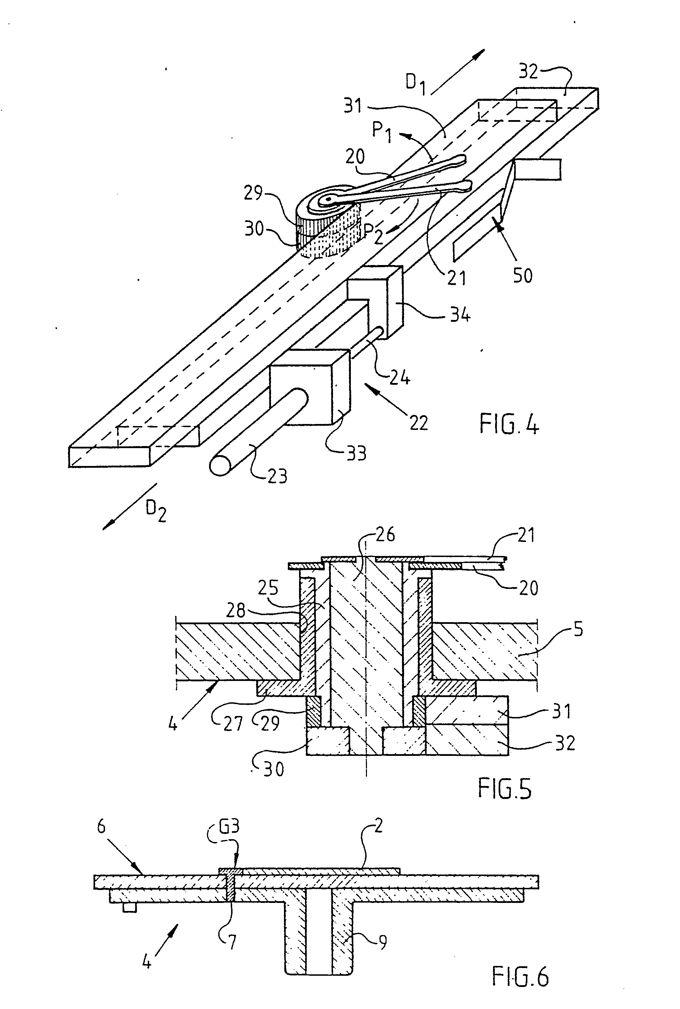

En se reportant aux figures 1 et 6, le système de référence (3) est formé par trois butées fixes avantageusement constituées, à titre d'exemple, par trois galets (G1, G2, G3) montés chacun rotatif autour d'un axe vertical fixe (7) supporté par la plaque (6) de la table de travail (4).

Ces trois galets (G1, G2, G3) définissent deux axes, un premier axe (X'X) passant par les deux galets (G1 et G2), et un second axe (Y'Y) perpendiculaire à l'axe (X'X) et passant par le troisième galet (G3). Il est à noter que le second axe (Y'Y) coupe le premier axe (X'X) en un point origine (O) situé en dehors de la partie de l'axe (X'X) située entre les deux galets (G1 et G2).

La plaque (6) possède sur sa surface inférieure ou surface opposée à celle recevant les galets (G1, G2 et G3), un bossage central cylindrique (9) et un pion de positionnement (10). Cette plaque (6) est rapportée sur la surface supérieure horizontale de la platine (5) (figure 1), en positionnant le bossage cylindrique (9) de la plaque (6) dans une ouverture centrale de la platine (5), ouverture qui se prolonge par un bossage annulaire (11) à l'intérieur duquel pénètre le bossage (9) de la plaque (6). Pour assurer un positionnement correct de cette plaque (6) par rapport à la platine (5), le pion de référence (10) coopère avec un dispositif de positionnement (12) possédant une ouverture dans laquelle pénètre le pion de référence (10).

En se reportant toujours à la figure 1, il est à noter que la plaque (6) possède une échancrure (15) de façon à laisser libre une zone (16) de la surface supérieure de la platine (5) non recouverte par cette plaque (6).

Le dispositif de positionnement (1) conforme à l'invention est essentiellement constitué par deux bras ou leviers de positionnement (20, 21) situés dans des plans horizontaux parallèles et susceptibles de pivoter dans deux directions opposées sous la commande d'un organe moteur unique constitué par exemple par un vérin (22) dont le corps (23) et la tige de piston (24) sont montés flottants.

La nature des liaisons entre les deux bras de positionnement (20, 21) et le vérin (22) est illustrée schématiquement sur les figures 4 et 5.

Les deux bras (20, 21) sont solidaires respectivement, vers une extrémité, des deux extrémités des deux axes co-axiaux verticaux (25, 26) supportés en rotation par la platine (5) de la table de travail (4). Ces deux axes sont montés à l'intérieur d'un même palier (27) lui-même monté dans un orifice (28) prévu dans la platine (5) de la table de travail (4), l'axe (25) étant un axe annulaire dans lequel est monté rotatif l'axe (26) ou axe central. Les deux autres extrémités libres de ces deux axes (25, 26), qui font saillie au-delà de la surface inférieure de la platine (5), sont respectivement solidaires en rotation de deux pignons fixes co-axiaux (29, 30) montés l'un au-dessus de l'autre, le pignon (29) associé à l'axe (25) étant situé à un niveau plus haut que le pignon (30) associé à l'axe (26). Ces deux pignons (29, 30) engrènent respectivement deux crémaillères (31, 32), à axe horizontal, chacune d'elle étant mobile en translation suivant son axe.

Le vérin (22) est monté parallèlement aux crémaillères (31, 32), avec son corps (23) solidaire de la crémaillère (32) et sa tige de piston (24) solidaire de la crémaillère (31), ces liaisons étant indiquées en (33 et 34).

Dans ces conditions, lorsque le vérin (22) est sous pression, sa tige (24) et son corps (23) se déplacent respectivement dans deux directions opposées (D1, D2) et entraînent respectivement le déplacement des crémaillères (31, 32) suivant ces deux mêmes directions opposées (D1 et D2). Les deux crémaillères (31, 32) entraînent par conséquent en rotation les pignons fixes (29, 30), dans deux sens de rotation inverses l'un de l'autre, ce qui a pour conséquence d'assurer le pivotement des bras (20, 21) dans deux directions inverses l'une de l'autre (P1, P2) respectivement.

Le principe du dispositif de positionnement conforme à l'invention illustré sur les figures (4) et (5) est repris dans un mode de réalisation de l'invention tel que représenté sur les figures (1 à 3).

Les deux bras de positionnement (20, 21) sont disposés horizontalement au niveau de la surface supérieure de la platine (5) de la table de travail (4) et dans la partie (16) de cette platine qui n'est pas recouverte par la plaque (6) supportant le système de référence (G1, G2, G3). Le mécanisme d'entraînement de ces deux bras (20, 21) est rapporté au niveau de la surface inférieure de la platine (5) de la table de travail (4). Plus précisément, le vérin (22) est monté parallèlement à l'axe (Y'OY) du système de référence (3), ainsi que les deux crémaillères (31, 32).

Il est à noter que les deux crémaillères (31, 32) sont constituées par deux plaques longitudinales montées coulissantes l'une sur l'autre et supportées par deux chapes (40, 41) solidaires de la platine (5). Deux côtés longitudinaux de ces deux plaques possèdent chacun un secteur denté sur lequel engrène le pignon associé. En effet, étant donné les déplacements de ces deux crémaillères, il n'est pas nécessaire que les secteurs dentés soient étendus sur toute la longueur des plaques. Les deux crémaillères (31, 32) sont respectivement associées à deux butées fixes (42, 43) contre lesquelles elles viennent respectivement en butée dans la position initiale des bras (20, 21) telle que représentée sur la figure 1, c'est-à-dire avant le positionnement du support (2).

Il est possible maintenant de décrire le procédé de positionnement automatique du support (2) sur la table de travail (4) par rapport au système de référence (3) constitué par les trois galets (G1, G2 et G3) portés par la plaque (6) rapportée sur la platine (5) de la table de travail.

Dans une première étape, le support (2) est disposé manuellement ou automatiquement sur la plaque (6) dans le quadrant (XOY) du système de référence (3). Le support (2) est positionné approximativement par rapport à ce système de référence (3), avec le côté latéral (C1) du support (2) au voisinage des galets (G1 et G2) et un côté latéral adjacent (C2) au voisinage du galet (G3) (support (2) représenté en traits mixtes sur la figure 1).

Dans une seconde étape, les bras de positionnement (20, 21) vont plaquer en deux temps le support (2) contre les galets (G1, G2 et G3) et assurer ainsi un positionnement précis du support (2) par rapport au système de référence (3). Comme cela a été explicité dans la description des figures 4 et 5, la mise en pression du vérin (22) entraîne le pivotement des deux bras (20, 21) dans les directions (P1 et P2), respectivement.

Dans un premier temps, le bras (20), par son extrémité libre qui supporte avantageusement un galet (44) monté en rotation dans un plan horizontal, vient en contact avec le côté latéral (C3) du support (2), afin d'entraîner en déplacement le support (2) et venir plaquer son côté latéral (C1), opposé au côté latéral (C3), contre les deux galets (G1) et (G2) situés sur l'axe (X'OX) du système de référence 3.

Dans un second temps, l'extrémité libre du bras (21) qui supporte également un galet (45) monté libre en rotation dans un plan horizontal, vient en contact avec le côté latéral (C4) du support (2). Le bras (21) va entraîner le support (2) suivant une direction de déplacement parallèle à l'axe (X'OX) du système de référence 3 afin d'amener son côté latéral (C2), opposé au côté latéral (C4), en appui contre le galet (G3) situé sur l'axe (Y'OY) du système de référence (3). Pendant ce déplacement, le côté latéral (C1) du support (2) reste en contact avec les galets (G1, G2) entraînés en rotation par le déplacement du support (2).

Selon l'invention, il faut donc que le bras de positionnement (21) agisse avec un léger retard par rapport au bras de positionnement (20). Etant donné que ces deux bras sont entraînés en pivotement par l'intermédiaire d'un organe de commande unique, il faut créer ce retard au niveau de la transmission de mouvement entre le vérin (22) et les bras (20, 21). Selon l'invention, on favorise le déplacement de la crémaillère (31) par rapport à la crémaillère (32), grâce à une lame frein (50) qui vient en appui contre la crémaillère (32) associée au bras (21), en un endroit situé en dehors du secteur denté porté par cette crémaillère. Dans ces conditions, lorsque le vérin (22) est mis sous pression, la lame frein (50) oppose une résistance au déplacement de la crémaillère (32), favorisant de ce fait le déplacement de la crémaillère (31). Ainsi, le bras (20) sera entraîné en pivotement en avance par rapport au bras (21).

Le vérin (22) est avantageusement un vérin à double effet afin d'assurer le retour en position initiale des deux bras de positionnement (20, 21) en ramenant les deux crémaillères (31, 32) respectivement en contact avec les butées (42, 43).

Dans l'exemple illustré, l'organe de commande (22) des deux bras (20, 21) est constitué par un vérin, mais tout autre organe de commande pourrait être utilisé à condition qu'il possède ou qu'il entraîne directement ou indirectement deux éléments mobiles dans deux directions opposées, ces éléments étant respectivement associés aux deux bras de positionnement. En variante, il est possible que les deux axes d'entraînement (25, 26) des deux bras (20, 21) ne soient pas coaxiaux, mais simplement parallèles entre eux.

Un tel dispositif de positionnement peut être inclus dans un cycle de travail automatique, notamment pour la fabrication de supports de circuits de connexions à couches épaisses à l'aide d'une machine de sérigraphie où le dispositif conforme à l'invention sert à positionner avec précision les supports sur la table de travail de la machine de sérigraphie.

## Revendications

1. Dispositif de positionnement automatique d'une pièce rectangulaire (2), telle qu'un support de composants électroniques, sur une table de travail (4), comprenant trois butées fixes (G1, G2, G3) définissant le quadrant d'un système de référence (XOY) et recevant deux côtés adjacents (C1, C2) du support, et deux bras presseurs (20, 21) rétractables dans un plan sensiblement parallèle à la table de travail pour la mise en place du support sur la table dans le quadrant et venant respectivement s'appuyer sur les deux côtés (C3, C4) du support, caractérisé en ce que les deux bras presseurs (20, 21) sont respectivement solidaires, par une de leurs extrémités, de deux axes verticaux (25, 26) entraînés en rotation en sens inverse l'un de l'autre par un organe moteur unique (22) pour amener d'abord l'un puis l'autre desdits deux côtés adjacents (C1, C2) contre leurs butées respectives.

2. Dispositif selon la revendication 1, caractérisé en ce que l'organe moteur unique (22) comprend au moins deux éléments mobiles dans deux directions opposées et respectivement associés aux deux axes précités (25, 26).

3. Dispositif selon la revendication 2, caractérisé en ce que l'organe moteur unique est constitué par un vérin (22) dont le corps (23) et la tige de piston (24) sont montés flottants avec la tige de vérin (24) solidaire d'une première crémaillère (31) mobile qui engrène un premier pignon fixe (29) solidaire en rotation de l'axe d'entraînement (25) de l'un des bras de positionnement (20) et avec le corps de piston (23) solidaire d'une seconde crémaillère (32) mobile, parallèle à la première crémaillère (31), et qui engrène un deuxième pignon fixe (30) solidaire en rotation de l'axe d'entraînement de l'autre bras de positionnement (21), les deux axes d'entraînement (25, 26) étant coaxiaux.

4. Dispositif selon la revendication 4, caractérisé en ce que le déplacement de la seconde crémaillère (32) associée au déplacement du bras de positionnement (21) contre la troisième butée (G3) du système de référence (3) est freiné, par une lame frein (50) par exemple, pour favoriser le déplacement de la première crémaillère (31), cette lame frein (50) entraînant un retard du pivotement du bras (21) qui assure ainsi le positionnement du support (2) contre la troisième butée (G3) du système de référence (3) après le positionnement du support contre les deux butées (G1, G2).

5. Dispositif selon la revendication 3 ou 4, caractérisé en ce que le vérin (22) précité est un vérin à double effet pour pouvoir ramener en position initiale les deux bras de positionnement, le déplacement des deux crémaillères (31, 32) étant limité par deux butées (42, 43) respectivement.

## Claims

1. Device for automatic positioning of a rectangular element (2), such as a carrier for electronic components, on a work table (4), comprising three fixed stops (G1, G2, G3) defining the quadrant of a reference system (XOY) and receiving two adjacent sides (C1, C2) of the carrier, and two presser arms (20, 21) retractable in a plane substantially parallel to the work table for the positioning of the carrier in the quadrant on the table and bearing, respectively, on the two other sids (C3, C4) of the carrier, characterised in that the two presser arms (20, 21) are respectively connected, by one of their extremities, to two vertical spindles (25, 26) driven in rotation in opposite directions with respect to each other by means of a single driving member (22) so as to bring first the one then the other of the said two adjacent sides (C1, C2) against their respective stops.

2. Device according to claim 1, characterised in that the single driving member (22) comprises at least two elements movable in two opposite directions and respectively associated with the two aforesaid spindles (25, 26).

3. Device according to claim 2, characterised in that the single driving member is formed by a jack (22) of which the body (23) and the piston rod (24) are mounted in floating manner with the piston rod (24) connected with a first movable rack (31) which meshes with a first fixed pinion (29) locked in rotation with the driving spindle (25) of one of the positioning arms (20) and with the piston body (23) connected with a second movable rack (32) parallel to the first rack (31), and which meshes with a second fixed pinion (30) locked in rotation with the driving spindle of the other positioning arm (21), the two driving spindles (25, 26) being co-axial.

4. Device according to claim 4, charcterised in that the displacement of the second rack (32) associated with the displacement of the positioning arm (21) against the third stop (G3) of the reference system (3) is bracked, by means of a braking blade (50) for example, to promote the displacement of the first rack (31), this braking blade (50) causing a delay of the pivoting of the arm (21) which thus assures the positioning of the carrier (2) against the third stop (G3) of the reference system (3) after the positioning of the carrier against the two stops (G1, G2).

5. Device according to claim 3 or 4, characterised in that the said jack (22) is a double-acting jack, so that the two positioning arms may be returned to the initial position, the displacement of the two racks (31, 32) being limited by two respective stops (42, 43).

**Patentansprüche**

1. Vorrichtung zur automatischen Positionierung eines rechtwinkligen Teils (2) wie ein Träger für elektronische Bauteile auf einem Arbeitstisch (4), mit drei festen Anschlägen (G1, G2, G3), die den Quadranten eines Referenzsystems (XOY) definieren und zwei angrenzende Seiten (C1, C2) des Trägers entgegennehmen, und mit zwei Druckarmen (20, 21), die in eine Ebene einziehbar sind, welche im wesentlichen parallel zu dem Arbeitstisch ist, um den Träger auf dem Tisch in dem Quadranten in Stellung zu bringen und sich gegen die zwei anderen Seiten (C3, C4) des Trägers abzustützen, dadurch gekennzeichnet, daß die zwei Druckarme (20, 21) an ihrem einen Ende je mit einer von zwei senkrechten Achsen (25, 26) fest verbunden sind, welche in zueinander entgegengesetztem Sinne durch ein einziges Antriebsorgan (22) in Drehung versetzt werden, um zunächst die eine und dann die andere der zwei angrenzenden Seiten (C1, C2) gegen die entsprechenden Anschläge zu bewegen.

2. Vorrichtung nach Anspruch 1, dadurch gekennzeichnet, daß das einzige Antriebsorgan (22) wenigstens zwei Elemente umfaßt, die in zwei entgegengesetzten Richtungen beweglich sind und jeweils einer der zwei genannten Achsen (25, 26) zugeordnet sind.

3. Vorrichtung nach Anspruch 2, dadurch gekennzeichnet, daß das einzige Antriebsorgan durch einen Arbeitszylinder (22) gebildet ist, dessen Körper (23) und Kolbenstange (24) schwimmend gelagert sind, wobei die Stange (24) des Arbeitszylinders fest mit einer ersten beweglichen Zahnstange (31) verbunden ist, welche mit einem ersten feststehenden Ritzel (29) kämmt, das drehfest mit der Antriebsachse (25) eines der Positionierarme (20) verbunden ist, während der Kolbenkörper (23) fest mit einer zweiten beweglichen Zahnstange (32) verbunden ist, die parallel zu der ersten Zahnstange (31) ist und mit einem zweiten feststehenden Ritzel (30) kämmt, das drehfest mit der Antriebsachse des anderen Positionierarmes (21) verbunden ist, wobei die beiden Antriebsachsen (25, 26) koaxial sind.

4. Vorrichtung nach Anspruch 4, dadurch gekennzeichnet, daß die Bewegung der zweiten Zahnstange (32), welche der Bewegung des Positionierarmes (21) gegen den dritten Anschlag (G3) des Referenzsystems (3) zugeordnet ist, beispielsweise durch eine Bremsscheibe (50) gebremst ist, um die Bewegung der ersten Zahnstange (31) zu bevorzugen, wobei diese Bremsscheibe (50) eine Verzögerung der Schwenkbewegung des Armes (21) nach sich zieht, welcher so die Positionierung des Trägers (2) gegen den dritten Anschlag (G3) des Referenzsystems (3) gewährleistet, nachdem die Positionierung des Trägers gegen die zwei Anschläge (G1, G2) erfolgte.

5. Vorrichtung nach Anspruch 3 oder 4, dadurch gekennzeichnet, daß der genannte Arbeitszylinder (22) doppelt wirkend ausgebildet ist, um die zwei Positionierarme in ihre Anfangsstellung zurückbringen zu können, wobei die Bewegung der zwei Zahnstangen (31, 32) jeweils durch einen von zwei Anschlägen (42, 43) begrenzt wird.

FIG.2

FIG.1

FIG.3

FIG.4

FIG.5

FIG.6